# EUROPEAN PATENT APPLICATION

(11) **EP 1 384 509 A2**
(43) Date of publication of application: **28.01.2004**
(21) Application number: 03076957.4
(22) Date of filing: 24.06.2003
(51) Int. Cl.: B01L 3/00

(54) **Protein crystallography hanging drop lid that individually covers each of the wells in a microplate**

(30) Priority: 24.06.2002 US 178317
(71) Applicant: Corning Incorporated, Corning, New York 14831 (US)
(72) Inventor: Sha, Ma, Shirley, MA 01464 (US); Youngbear, Kathy Marie, Cambridge, Ma 02139 (US)
(74) Representative: Poole, Michael John

(57) **Abstract**

A lid that individually covers each of the wells in a microplate and methods for fabricating and using the lid are described herein. The lid includes a series of downwardly protruding necks each of which is sized to fit and seal against one of the wells formed within the microplate. And, each neck has a surface covered with a rubber-like substance that ensures a relatively tight seal with each well. In operation, the lid and microplate are preferably used together to grow protein crystals using a hanging drop vapor diffusion crystallization process.

## Description

### BACKGROUND OF THE INVENTION

### Field of the Invention

The present invention relates in general to the biotechnology field and, in particular, to a protein crystallography hanging drop lid designed to individually cover each of the wells in a microplate and methods for fabricating and using the protein crystallography hanging drop lid.

### Description of Related Art

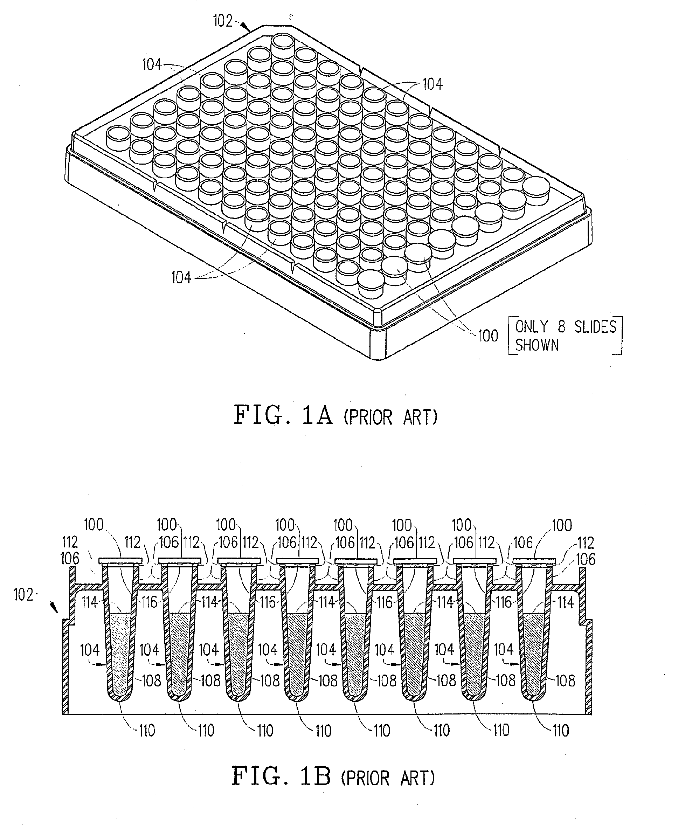

Today biochemical studies associated with growing protein crystals and other biological crystals are carried out on a large scale in both industry and academia. As such, it is desirable to have an apparatus that allows researchers to perform these studies in a convenient and inexpensive fashion. Because they are relatively easy to handle and low in cost, microplates are often used in these studies. And, if the study involves growing protein crystals via a hanging drop vapor diffusion process, then the wells of a microplate are often covered with slides or a lid having one or more drops of a protein solution and a reagent solution hanging therefrom which turn into the protein crystals. In particular, the drops hanging from the bottom side of the slides or lid turn into protein crystals by interacting via a vapor diffusion process with a higher concentrated reagent solution located within each well of the microplate. However, the traditional slides or lid used to grow protein crystals in this manner have several drawbacks which are described in greater detail below with reference to FIGURES 1-3.

Referring to FIGURES 1A-1B (PRIOR ART), there are illustrated different views of one set of traditional slides 100 designed to cover the wells 104 in a microplate 102. Each slide 100 typically has a circular shape and is sized to fit over one of the wells 104 in the microplate 102. And, each well 104 includes a rim 106, sidewalls 108 and a bottom 110 (see FIGURE 1B). The wells 104 are generally arranged in a matrix of mutually perpendicular rows and columns. For example, the microplate 102 can include a matrix of wells 104 having dimensions of 4x6 (24 wells), 8x12 (96 wells) and 16x24 (384 wells). The microplate 102 shown includes an array of ninety-six wells 104.

To grow a protein crystal on the bottom side of one slide 100, the researcher applies a bead of grease 112 (e.g., high vacuum grease) along the rim 106 of one of the wells 104. Typically, the researcher would leave a small opening such as 2mm between the start and end of the bead of grease 112. The researcher then pipets a small amount (e.g., 1.0 millimeter) of a reagent solution 114 into the well 104. One or more drops 116 (only one shown) including a small amount of a protein sample (e.g., 1.0 microliter) and a small amount of a reagent solution (1.0 microliter) that can be taken from the well 104 are then pipetted onto a bottom side of the slide 100. Thereafter, the researcher inverts the slide 100 so that the drop 116 is hanging down from the slide 100 and then positions and places the slide 100 onto the grease 112 around the well 104. To relieve the air pressure within the well 104, the researcher presses the slide 100 down onto the grease 112 and twists the slide 100 to close the small opening in the grease 112. This process is then completed for each well 104 in the microplate 102. Unfortunately, there are a number of disadvantages associated with using the slides 100 and the microplate 102. First, the researcher must work with messy grease 112 and possibly spend a lot of time applying the grease 112 to the rims 106 of each well 104. Secondly, the researcher must work with and handle a large number of relatively small slides 100 to utilize all of the wells 104 in the microplate 102. Thirdly, the slides 100 and the grease 112 are expensive.

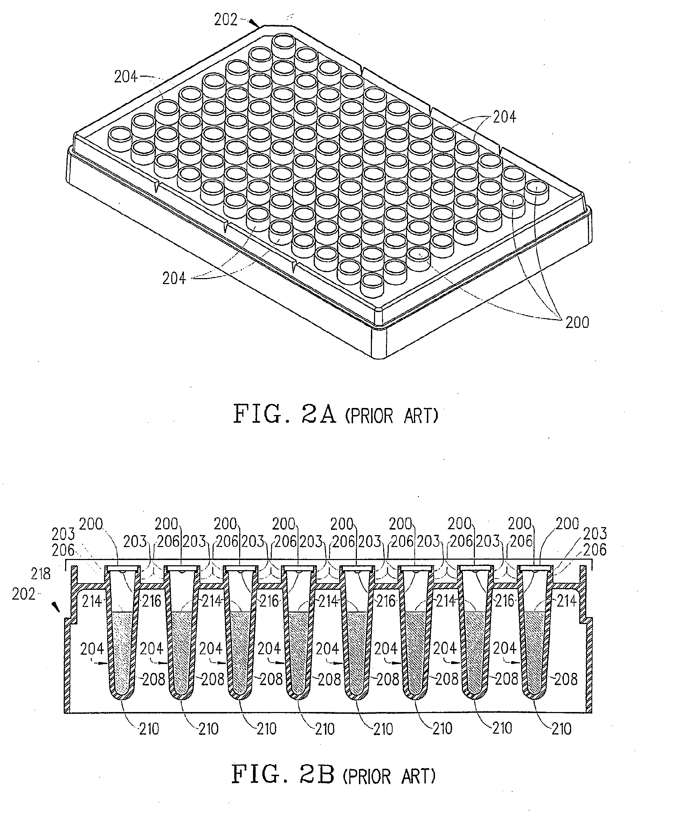

Referring to FIGURES 2A-2B (PRIOR ART), there are illustrated different views of another set of traditional slides 200 designed to cover the wells 204 in a microplate 202. Each slide 200 typically has a circular shape and is sized to be placed on a ledge 203 in one of the wells 204 in the microplate 202. And, each well 204 includes a rim 206, sidewalls 208 and a bottom 210. The wells 204 are generally arranged in a matrix of mutually perpendicular rows and columns. For example, the microplate 202 can include a matrix of wells 204 having dimensions of 4x6 (24 wells), 8x12 (96 wells) and 16x24 (384 wells). The microplate 202 shown includes an array of ninety-six wells 204.

To grow a protein crystal on the bottom side of one slide 200, the researcher pipets a small amount (e.g., 1.0 millimeter) of a reagent solution 214 into the well 204. One or more drops 216 (only one shown) including a small amount of a protein sample (e.g., 1.0 microliter) and a small amount of a reagent solution (1.0 microliter) that can be taken from the well 204 are then pipetted onto a bottom side of the slide 200. Thereafter, the researcher inverts the slide 200 so that the drop 216 is hanging down from the slide 200 and then positions and places the slide 200 onto the ledge 203 within the well 204. After, this process is completed for each well 204 in the microplate 202, then the researcher places one or more strips of tape 218 (only shown in FIGURE 2B) over the top of microplate 202. Unfortunately, there are a number of disadvantages associated with using the slides 200 and the microplate 202. First, the researcher must work with and handle a large number of relatively small slides 200 to utilize all of the wells 204 in the microplate 202. Secondly, the researcher must cut the tape 218 in order to have access to anyone of the slides 200 located within a particular well 204. Thirdly, the slides 200 are expensive.

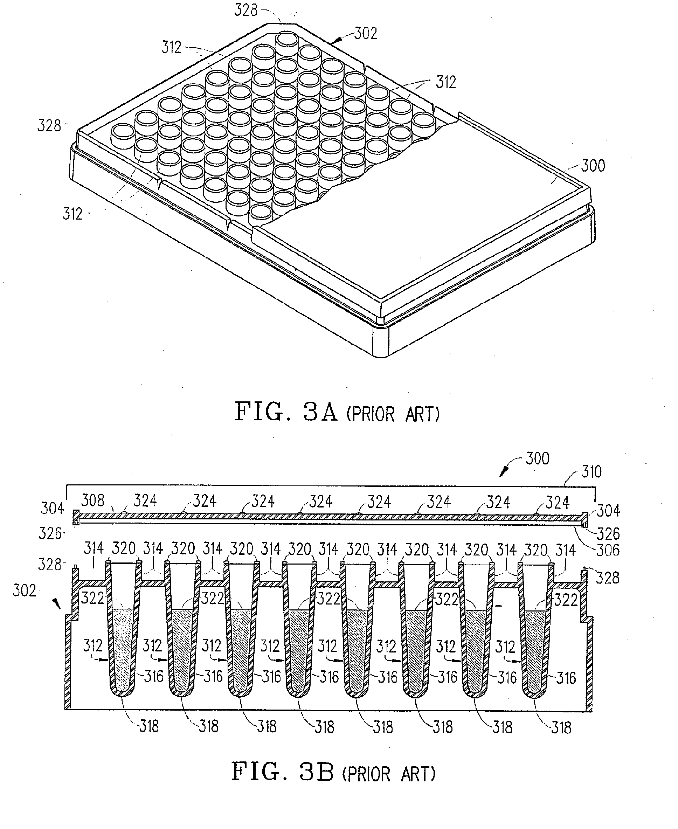

Referring to FIGURES 3A-3B (PRIOR ART), there are illustrated different views of a traditional lid 300 designed to cover the wells 312 in a microplate 302. The lid 300 includes a rigid frame 304 that supports a filter membrane 306 on which there is placed a hydrophobic mask 308 all of which are protected by a removable cover 310 (see exploded view in FIGURE 3B) . The lid 300 is sized to fit over all of the wells 312 in the microplate 302. And, each well 312 includes a rim 314, sidewalls 316 and a bottom 318. The wells 312 are generally arranged in a matrix of mutually perpendicular rows and columns. For example, the microplate 302 can include a matrix of wells 312 having dimensions of 4x6 (24 wells), 8x12 (96 wells) and 16x24 (384 wells). The microplate 302 shown includes an array of ninety-six wells 312.

To grow a group of protein crystals on top of the hydrophobic mask 308 of the lid 300, the researcher applies a bead of grease 320 (e.g., high vacuum grease) on the rims 314 of the wells 312 in the event the wells 312 are not pre-greased. The researcher then pipets a small amount (e.g., 1.0 millimeter) of a reagent solution 322 into each well 312. One or more drops 324 (eight drops 324 are shown) including a small amount of a protein sample (e.g., 1.0 microliter) and a small amount of a reagent solution (1.0 microliter) that can be taken from the well 104 are then pipetted onto the hydrophobic mask 308 of the lid 300. Thereafter, the researcher positions the lid 300 over the microplate 302 and then pushes the lid 300 down onto the grease 322 located around each well 312. The lid 300 can have holes 326 formed in the frame 304. And, the microplate 302 can have pins 328 extending up therefrom which fit into the holes 326 in the frame 304 to assure that the lid 300 is properly aligned with the microplate 302. Unfortunately, there are a number of disadvantages associated with using the lid 300 and the microplate 302. First, the researcher must work with messy grease 320 and possibly spend a lot of time applying the grease 320 to the rims 314 of the wells 312. Secondly, the filter membrane 306 and hydrophobic mask 308 of the lid 300 are very fragile and can easily break. Thirdly, the lid 300 is very expensive.

Accordingly, there is and has been a need for a cost effective and user-friendly lid that can be used with a microplate to help a researcher perform protein crystallization studies. This need and other needs are satisfied by the lid and the methods of the present invention.

### BRIEF DESCRIPTION OF THE INVENTION

The present invention includes a lid that individually covers each of the wells in a microplate and methods for fabricating and using the lid. The lid includes a series of downwardly protruding necks each of which is sized to fit and seal against one of the wells formed within the microplate. And, each neck has a surface covered with a rubber-like substance that ensures a relatively tight seal with each well. In operation, the lid and microplate are preferably used together to grow protein crystals using a hanging drop vapor diffusion crystallization process.

### BRIEF DESCRIPTION OF THE DRAWINGS

A more complete understanding of the present invention may be had by reference to the following detailed description when taken in conjunction with the accompanying drawings wherein:
FIGURES 1A-1B (PRIOR ART) illustrates different views of one set of traditional slides made by Hampton Research Corporation that are designed to cover the wells in a microplate;
FIGURE 2A-2B (PRIOR ART) illustrates different views of another set of traditional slides made by Hampton Research Corporation that are designed to cover the wells in a microplate;
FIGURE 3A-3B (PRIOR ART) illustrates different views of a traditional lid made by Neuro Probe Incorporated that is designed to cover the wells in a microplate;
FIGURES 4A-4H are different views of a first embodiment of a lid designed to cover the wells of a microplate in accordance with the present invention;
FIGURES 5A-5H are different views illustrating a second embodiment of a lid designed to cover the wells of a microplate in accordance with the present invention;
FIGURES 6A-6H are different views illustrating a third embodiment of a lid designed to cover the wells of a microplate in accordance with the present invention;
FIGURES 7A-7C are partial cross-sectional side views of different microfluidic channels that can be incorporated within anyone of the lids shown in FIGURES 4-6;
FIGURE 8 is a flowchart illustrating the steps of a preferred method for using a lid and a microplate in accordance with the present invention; and
FIGURE 9 is a flowchart illustrating the steps of a preferred method for fabricating a lid in accordance with the present invention.

### DETAILED DESCRIPTION OF THE DRAWINGS

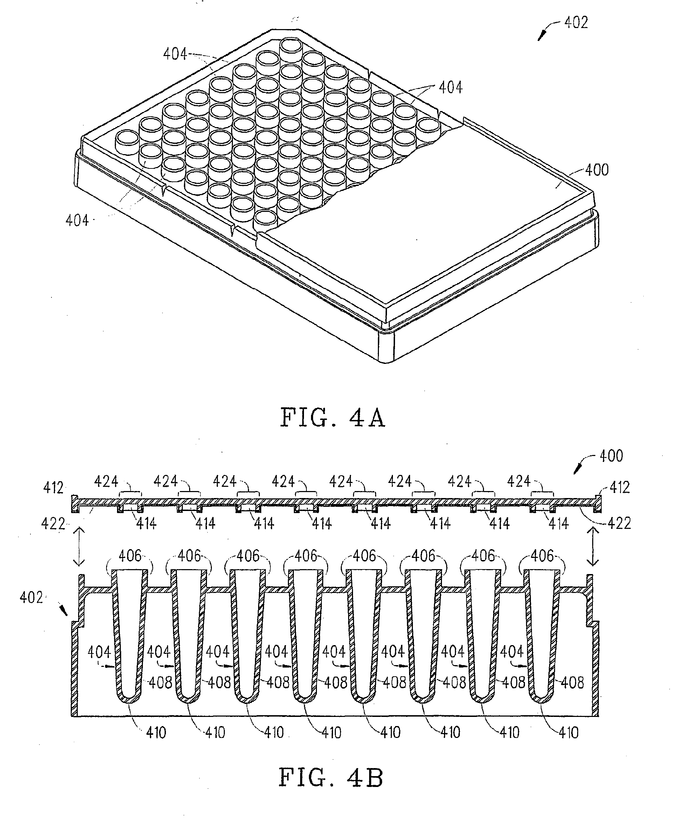

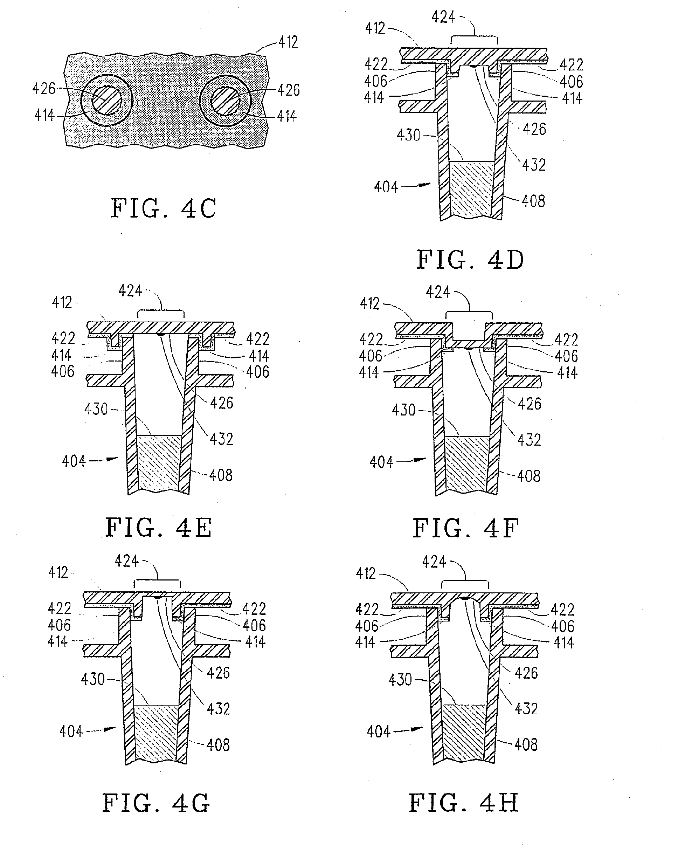

Referring to FIGURES 4-9, there are disclosed in accordance with the present invention several embodiments of a lid 400, 500 and 600 designed to cover a microplate 402, 502 and 602 and methods 800 and 900 for fabricating and using the lid. Although the lid 400, 500 and 600 and the microplate 402, 502 and 602 are described as being used to grow protein crystals using a hanging drop vapor diffusion crystallization process, it should be understood that the lid and microplate are not limited to this application. Instead, the lid 400, 500 and 600 can be used with the microplate 402, 502 and 602 to perform a wide variety of applications including one where the lid simply ensures that a solution remains within the wells of the microplate. Accordingly, the lid 400, 500 and 600 and the methods 800 and 900 for fabricating and using the lid should not be construed in a limited manner.

Referring to FIGURES 4A-4H, there are illustrated different views of a first embodiment of a lid 400 designed to cover the individual wells 404 of a microplate 402. The microplate 402 includes an array of wells 404 each of which has a rim 406, sidewalls 408 and a bottom 410. The wells 404 are generally arranged in a matrix of mutually perpendicular rows and columns. For example, the microplate 402 can include a matrix of wells 404 having dimensions of 4x6 (24 wells), 8x12 (96 wells) and 16x24 (384 wells). The microplate 402 shown includes an array of ninety-six wells 404.

The lid 400 (e.g., protein crystallography hanging drop lid 400) is sized and configured to individually cover each of the wells 404 in the microplate 402. In particular, the lid 400 includes a frame 412 having formed therein a series of downwardly protruding necks 414 (see cross-sectional side view in FIGURE 4B and partial bottom view in FIGURE 4C). Each neck 414 is designed to fit and seal against one of the wells 404 in the microplate 402. In one embodiment shown in FIGURE 4D, each neck 414 is designed to fit and seal against an inside edge of the rim 406 extending from one of the wells 404 in the microplate 402 (see also FIGURE 4B) . In another embodiment shown in FIGURE 4E, each neck 414 is designed to fit and seal against an outside edge of the rim 406 extending from one of the wells 404 in the microplate 402.

To ensure a relatively tight seal between each neck 414 and each well 404, all or a portion of the bottom side of the frame 412 and the outer surface of each neck 414 are covered with a rubber-like substance 422 (shown as shaded area). In the preferred embodiment, the rubber-like substance 422 is a thermoplastic elastomer. However, any rubber-like substance 422 can be used that has gasket-like characteristics with the appropriate flexure and friction properties that can ensure a consistently tight seal around the wells 404. The relatively tight seal between each neck 414 and each well 404, should be maintained regardless of the different dimensional tolerances of the wells 404, the hand assembly of the lid 400 to the microplate 402 and the movement of the lid 400 and microplate 402.

Each neck 414 has a transparent window 424 which is part of the frame 412 that enables a user to see inside each well 404 when the lid 400 is attached to the microplate 402. The window 424 is transparent because the frame 412 is preferably made from a clear substance such as polystyrene, cyclic olefin or polypropylene and the rubber-like substance 422 is a colored substance such as a colored thermoplastic elastomer. Alternatively, the rubber-like substance 422 could be clear and does not need to be colored. Each window 424 has a bottom side 426 that is located within an inner surface of the neck 414. In the embodiments shown in FIGURES 4D-4E, each window 424 has a flat bottom side 426 that is flush with a top of the rim 406 of the well 404. In another embodiment shown in FIGURE 4F, each window 424 has a flat bottom side 426 that is located within the well 404. In yet another embodiment shown in FIGURE 4G, each window 424 has a flat bottom side 426 that is located above the well 404. In still yet another embodiment shown in FIGURE 4H, each window 424 has a concaved bottom side 426. Of course, each window 424 may have a bottom side 426 with other shapes and locations other than those described above with respect to FIGURES 4D-4H.

To grow one or more protein crystals using the lid 400 and microplate 402, the researcher pipets a small amount (e.g., 1.0 millimeter) of a reagent solution 430 into each of the wells 404 (see, FIGURES 4D-4H). One or more drops 432 (only one shown) including a small amount of a protein sample (e.g., 1.0 microliter) and a small amount of a reagent solution (1.0 microliter) that can be taken from the wells 404 are then pipetted onto the bottom sides 426 of the necks 414. Thereafter, the researcher inverts the lid 400 so the drops 432 hang down from the lid 400 and then positions, pushes-down and secures the lid 400 onto the microplate 402. In this position, the drops 432 via a vapor diffusion process turn into protein crystals by interacting with the higher concentrated reagent solution 430 located within the wells 404 of the microplate 402. Instead of having the researcher handle the lid 400, the lid 400 can have a footprint which makes it capable of being handled by a robotic handling system (not shown).

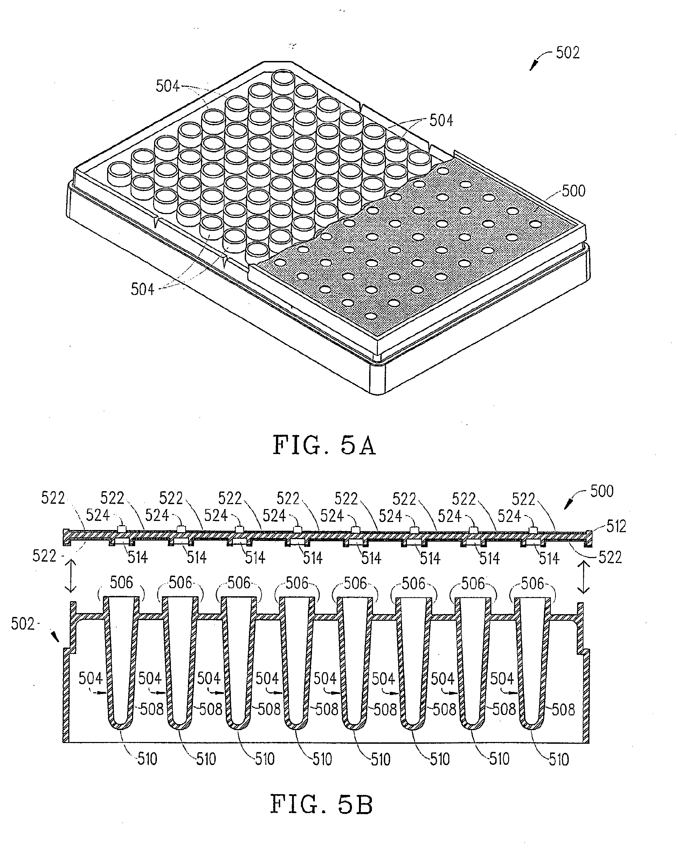

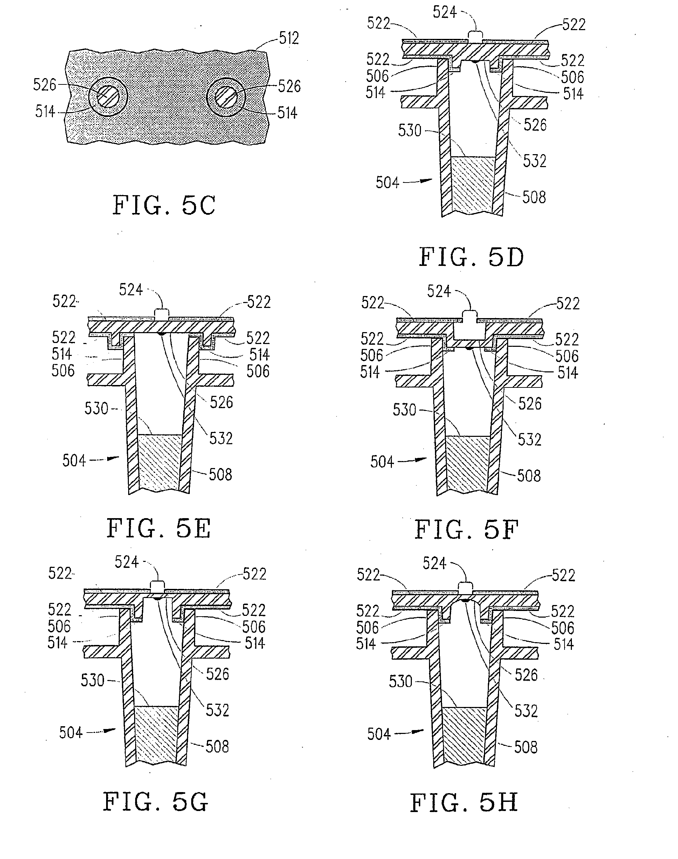

Referring to FIGURES 5A-5H, there are illustrated different views of a second embodiment of a lid 500 designed to cover the individual wells 504 of a microplate 502. The microplate 502 includes an array of wells 504 each of which has a rim 506, sidewalls 508 and a bottom 510. The wells 504 are generally arranged in a matrix of mutually perpendicular rows and columns. For example, the microplate 502 can include a matrix of wells 504 having dimensions of 4x6 (24 wells), 8x12 (96 wells) and 16x24 (384 wells). The microplate 502 shown includes an array of ninety-six wells 504.

The lid 500 (e.g., protein crystallography hanging drop lid 500) is sized and configured to individually cover each of the wells 504 in the microplate 502. In particular, the lid 500 includes a frame 512 having formed therein a series of downwardly protruding necks 514 (see cross-sectional side view in FIGURE 5B and partial bottom view in FIGURE 5C). Each neck 514 is designed to fit and seal against one of the wells 504 in the microplate 502. In one embodiment shown in FIGURE 5D, each neck 514 is designed to fit and seal against an inside edge of the rim 506 extending from one of the wells 504 in the microplate 502 (see also FIGURE 5B). In another embodiment shown in FIGURE 5E, each neck 514 is designed to fit and seal against an outside edge of the rim 506 extending from one of the wells 504 in the microplate 502.

To ensure a relatively tight seal between each neck 514 and each well 504, all or a portion of the bottom side and a portion of the top side of the frame 512 and the outer surface of each neck 514 are covered with a rubber-like substance 522 (shown as shaded area). In the second embodiment, the rubber-like substance 522 is also located on the top side of the frame 512 except where the windows 524 are located (compare to lid 400 in FIGURE 4B) . In the preferred embodiment, the rubber-like substance 522 is a thermoplastic elastomer. However, any rubber-like substance 522 can be used that has gasket-like characteristics with the appropriate flexure and friction properties that can ensure a consistently tight seal around the wells 504. The relatively tight seal between each neck 514 and each well 504, should be maintained regardless of the different dimensional tolerances of the wells 504, the hand assembly of the lid 500 to the microplate 502 and the movement of the lid 500 and microplate 502.

Each neck 514 has a transparent window 524 which is part of the frame 512 that enables a user to see inside each well 504 when the lid 500 is attached to the microplate 502. The window 524 is transparent because the frame 512 is preferably made from a clear substance such as polystyrene, cyclic olefin or polypropylene and the rubber-like substance 522 is a colored substance such as a colored thermoplastic elastomer. Alternatively, the rubber-like substance 522 could be clear and does not need to be colored. Each window 524 has a bottom side 526 that is located within an inner surface of the neck 514. In the embodiments shown in FIGURES 5D-5E, each window 524 has a flat bottom side 526 that is flush with a top of the rim 506 of the well 504. In another embodiment shown in FIGURE 5F, each window 524 has a flat bottom side 526 that is located within the well 504. In yet another embodiment shown in FIGURE 5G, each window 524 has a flat bottom side 526 that is located above the well 504. In still yet another embodiment shown in FIGURE 5H, each window 524 has a concaved bottom side 526. Of course, each window 524 may have a bottom side 524 with other shapes and locations other than those described above with respect to FIGURES 5D-5H.

To grow one or more protein crystals using the lid 500 and microplate 502, the researcher pipets a small amount (e.g., 1.0 millimeter) of a reagent solution 530 into each of the wells 504 (see, FIGURES 5D-5H). One or more drops 532 (only one shown) including a small amount of a protein sample (e.g., 1.0 microliter) and a small amount of a reagent solution (1.0 microliter) that can be taken from the wells 504 are pipetted onto the bottom sides 526 of the necks 514. Thereafter, the researcher inverts the lid 500 so the drops 532 hang down from the lid 500 and then positions, pushes-down and secures the lid 500 onto the microplate 502. In this position, the drops 532 via a vapor diffusion process turn into protein crystals by interacting with the higher concentrated reagent solution 530 located within the wells 504 of the microplate 502. Instead of having the researcher handle the lid 500, the frame 512 of the lid 500 can have a footprint which makes it capable of being handled by a robotic handling system (not shown).

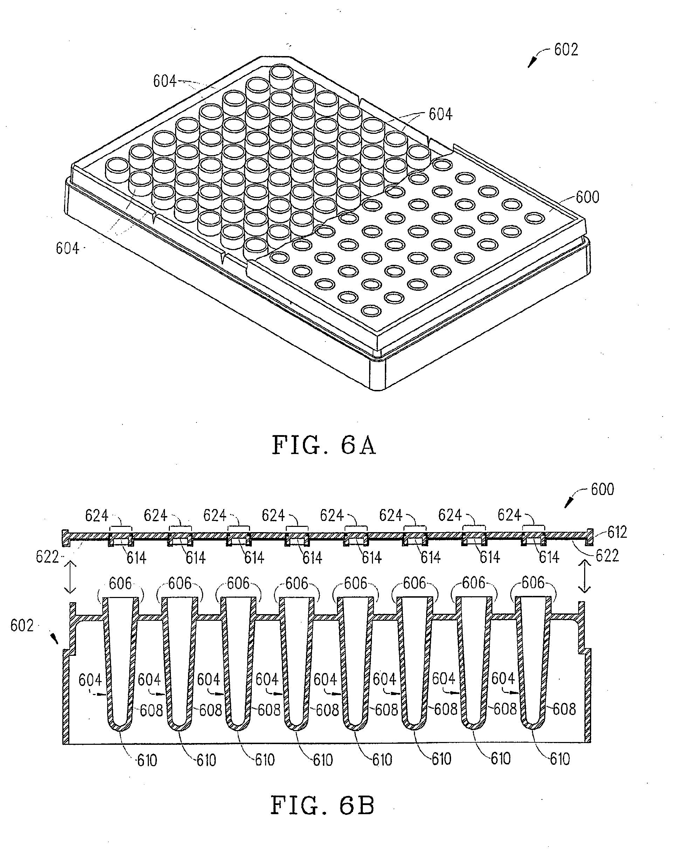

Referring to FIGURES 6A-6H, there are illustrated different views of a third embodiment of a lid 600 designed to cover the individual wells 604 of a microplate 602. The microplate 602 includes an array of wells 604 each of which has a rim 606, sidewalls 608 and a bottom 610. The wells 604 are generally arranged in a matrix of mutually perpendicular rows and columns. For example, the microplate 602 can include a matrix of wells 604 having dimensions of 4x6 (24 wells), 8x12 (96 wells) and 16x24 (384 wells). The microplate 602 shown includes an array of ninety-six wells 604.

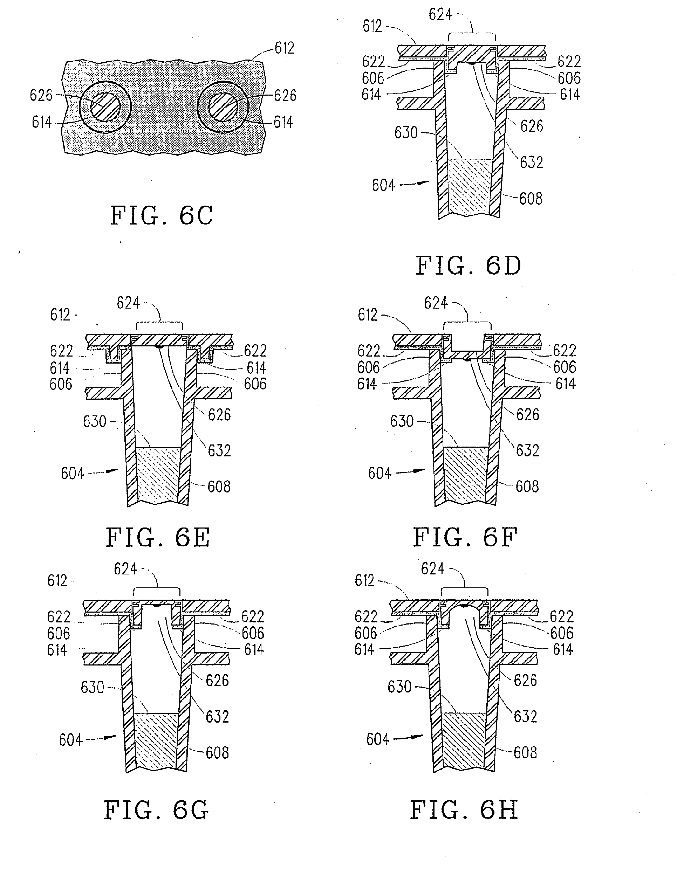

The lid 600 (e.g., protein crystallography hanging drop lid 600) is sized and configured to individually cover each of the wells 604 in the microplate 602. In particular, the lid 600 includes a frame 612 having formed therein a series of downwardly protruding necks 614 (see cross-sectional side view in FIGURE 6B and partial bottom view in FIGURE 6C). Each neck 614 is designed to fit and seal against one of the wells 604 in the microplate 602. In one embodiment shown in FIGURE 6D, each neck 614 is designed to fit and seal against an inside edge of the rim 606 extending from one of the wells 604 in the microplate 602 (see also FIGURE 6B) . In another embodiment shown in FIGURE 6E, each neck 614 is designed to fit and seal against an outside edge of the rim 606 extending from one of the wells 604 in the microplate 602.

To ensure a relatively tight seal between each neck 614 and each well 604, all or a portion of the bottom side and a portion of the top side of the frame 612 and an outer surface of each neck 614 are covered with a rubber-like substance 622 (shown as shaded area). In addition, as can be best seen in FIGURES 6D-6H, the rubber-like substance 622 is located within portions of the frame 612 itself and on part of the top side of the frame 612 (compare to lids 400 and 500 in FIGURES 4B and 5B). The location of the rubber-like substance 622 within the frame 612 itself can help the rubber-like substance to adhere to the frame 612 better than if it was just located on the top side and/or bottom side of the frame 612. In the preferred embodiment, the rubber-like substance 622 is a thermoplastic elastomer. However, any rubber-like substance 622 can be used that has gasket-like characteristics with the appropriate flexure and friction properties that can ensure a consistently tight seal around the wells 604. The relatively tight seal between each neck 614 and each well 604, should be maintained regardless of the different dimensional tolerances of the wells 604, the hand assembly of the lid 600 to the microplate 602 and the movement of the lid 600 and microplate 602.

Each neck 614 has a transparent window 624 which is part of the frame 612 that enables a user to see inside each well 604 when the lid 600 is attached to the microplate 602. The window 624 is transparent because the frame 612 is preferably made from a clear substance such as polystyrene, cyclic olefin or polypropylene and the rubber-like substance 622 is a colored substance such as a colored thermoplastic elastomer. Alternatively, the rubber-like substance 622 could be clear and does not need to be colored. Each window 624 has a bottom side 626 that is located within an inner surface of the neck 614. In the embodiments shown in FIGURES 6D-6E, each window 624 has a flat bottom side 626 that is flush with a top of the rim 606 of the well 604. In another embodiment shown in FIGURE 6F, each window 624 has a flat bottom side 626 that is located within the well 604. In yet another embodiment shown in FIGURE 6G, each window 624 has a flat bottom side 626 that is located above the well 604. In still yet another embodiment shown in FIGURE 6H, each window 624 has a concaved bottom side 626. Of course, each window 624 may have a bottom side 624 with other shapes and locations other than those described above with respect to FIGURES 6D-6H.

To grow one or more protein crystals using the lid 600 and microplate 602, the researcher pipets a small amount (e.g., 1.0 millimeter) of a reagent solution 630 into each of the wells 604 (see, FIGURES 6D-6H). One or more drops 632 (only one shown) including a small amount of a protein sample (e.g., 1.0 microliter) and a small amount of a reagent solution (1.0 microliter) that can be taken from the wells 604 are pipetted onto the bottom sides 626 of the necks 614. Thereafter, the researcher inverts the lid 600 so the drops 630 are hanging down from the lid 600 and then positions, pushes-down and secures the lid 600 onto the microplate 602. In this position, the drops 632 via a vapor diffusion process turn into protein crystals by interacting with the higher concentrated reagent solution 630 located within the wells 604 of the microplate 602. Instead of having the researcher handle the lid 600, the frame 612 of the lid 600 can have a footprint which makes it capable of being handled by a robotic handling system (not shown).

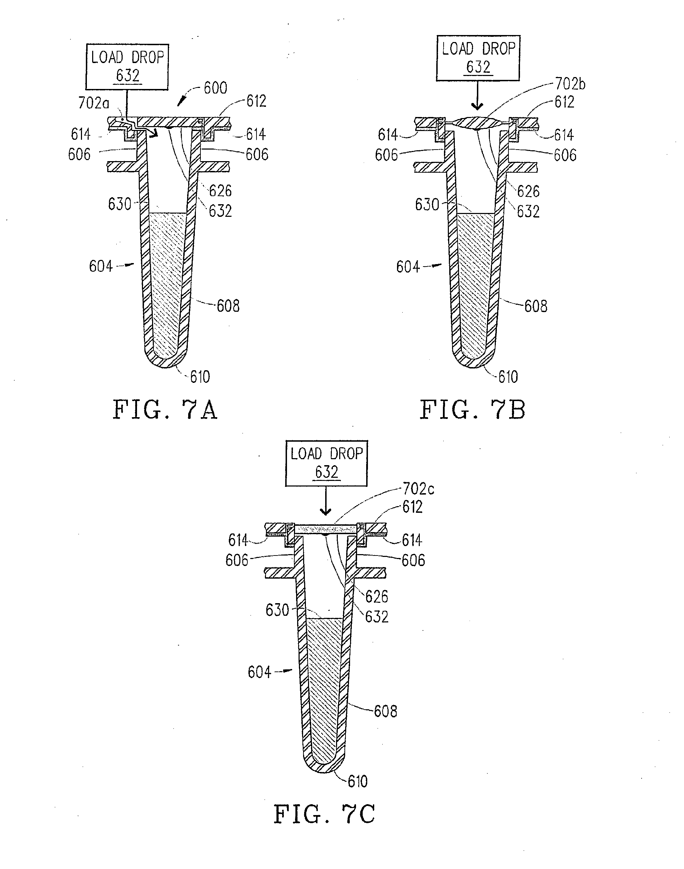

Referring to FIGURES 7A-7C, there are illustrated partial cross-sectional side views of lid 600 having incorporated therein a microfluidic channel 702a, 702b and 702c that is associated with each neck 614. The microfluidic channel 702a, 702b and 702c enables the researcher to load a drop 632 from the top side of the lid 600 and have the drop 632 slide onto the bottom side 626 of the neck 614. In particular, the drop 632 can move via microfluidic transfer or capillary transfer through the microfluidic channel 702a, 702b and 702c onto the bottom side 626 of the neck 614. Alternatively, the research can use a liquid handling device such as a pipet to force fluid through the micro-channel 702a, 702b and 702c to load the drop 632 on the bottom side 626 and the neck 614. After loading all the drops 632 so that they are hanging from all the necks 614, the researcher can seal the lid 600 using clear tape (not shown) to prevent the evaporation of the drops 632 and the reagent solutions 630 in the wells 604. In other words, the researcher can connect the lid 600 to the microplate 602 and then load the drops 632 from the top side of the lid 600 onto the bottom sides 626 of the necks 614. It should be noted that lids 400 and 500 in addition to lid 600 can also incorporate the microfluidic channels 702a, 702b and 704c.

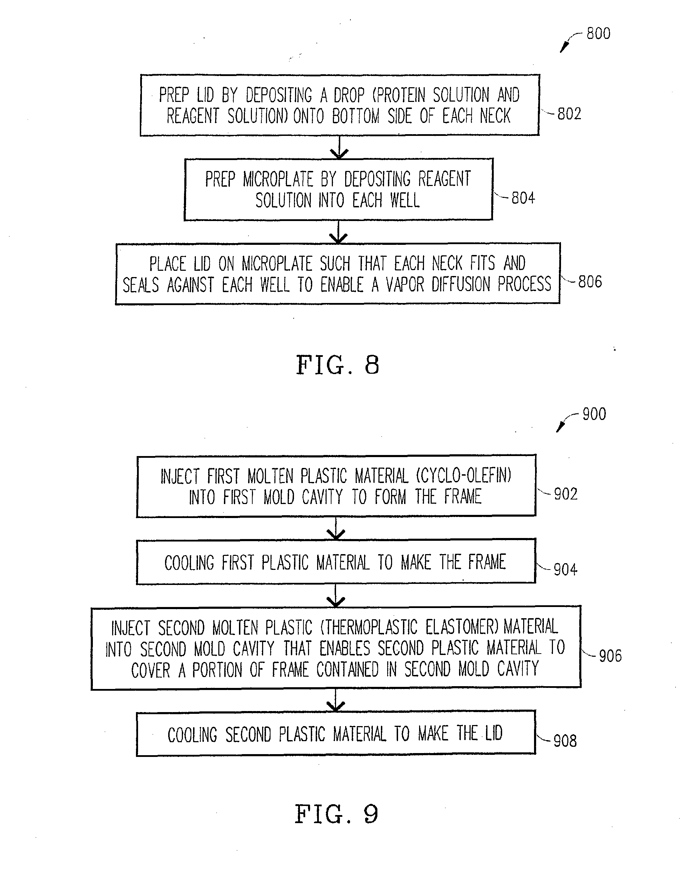

Referring to FIGURE 8, there is a flowchart illustrating the steps of a preferred method 800 for using the lid 400, 500 and 600 and the microplate 402, 502 and 602. The lid 400, 500 and 600 of the present invention is generally described as being coupled with the microplate 402, 502 and 602 to form a protein crystallography system. The protein crystallography system can be used to grow protein crystals using a hanging drop vapor diffusion crystallization process.

Beginning at step 802, the lid 400, 500 and 600 is prepped by depositing one or more drops 432, 532 and 632 onto the bottom side 426, 526 and 626 of each neck 414, 514 and 614. As described above, each drop 432, 532 and 632 includes a small amount of a protein sample (e.g., 1.0 microliter) and a small amount of a reagent solution (1.0 microliter).

At step 804, the microplate 402, 502 and 602 is prepped by depositing the reagent solution 430, 530 and 630 into one or more wells 404, 504 and 604. As described above, the researcher would pipet a small amount (e.g., 1.0 millimeter) of the reagent solution 430, 530 and 630 into each well 404, 504 and 604 of the microplate 402, 502 and 602. The reagent solution 430, 530 and 630 located in each well 404, 504 and 604 would have a relatively greater or higher concentration than the reagent solution incorporated in the drops 432, 532 and 632. It should be understood that the order of steps 802 and 804 can be reversed to enable the researcher to take a small amount of the reagent solution 430, 530 and 630 from the wells 404, 504 and 604 to form each drop 432, 532 and 632.

At step 806, the lid 400, 500 and 600 is placed over and pushed onto the microplate 402, 502 and 602 such that each neck 414, 514 and 614 fits and seals against the rim 406, 506 and 606 of each well 404, 504 and 604. In this position, the drops 432, 532 and 632 on the bottom side 426, 526 and 626 of the necks 414, 514 and 614 can interact via a vapor diffusion process with the reagent solution 430, 530 and 630 within each well 404, 504 and 604 which enables the formation of protein crystals on the bottom sides 426, 526 and 626 of necks 414, 514 and 614. Of course, if microfluidic channels 702a, 702b and 702c are incorporated into the lid 400, 500 and 600. Then the drops 432, 532 and 632 could be deposited onto the bottom sides 426, 526 and 626 of the necks 414, 514 and 614 after the lid 400, 500 and 600 is attached to the microplate 402, 502 and 602.

Referring to FIGURE 9, there is a flowchart illustrating the steps of a preferred method 900 for making the lid 400, 500 and 600. Beginning at step 902, a first molten plastic material is injected into a first mold cavity that includes sections shaped to form the frame 412, 512 and 612 of the lid 400, 500 and 600. Then at step 904, the first plastic material is cooled to resemble the frame 412, 512 and 612. Preferably, the first plastic material is a clear cyclic-olefin, polystyrene or polypropylene.

At step 906, a second molten plastic material 422, 522 and 622 (e.g., rubber-like substance 422, 522 and 622) is injected into a second mold cavity that includes sections shaped to contain the frame 412, 512 and 612 and to enable the second plastic material 422, 522 and 622 to cover at least a portion of the outer surface, 520 and 620 of each neck 414, 514 and 614 formed in the frame 412, 512 and 612 (see FIGURES 4B, 5B and 6B). Finally at step 908, the second plastic material (e.g., rubber-like substance 422, 522 and 622) that was added to the frame 412, 512 and 612 is cooled to form the lid 400, 500 and 600. Preferably, the second plastic material is a colored thermoplastic elastomer. Alternatively, the second plastic material could be clear thermoplastic elastomer.

The preferred method 900 can utilize at least two different molding processes to fabricate the two-component lid 400, 500 and 600. One of these molding processes is generally known as overmolding or insert molding wherein the frame 412, 512 and 612 would be molded on a separate machine and then placed into a second machine whose mold cavity accepts the frame 412, 512 and 612 and also has a detail for the addition of the rubber-like substance 422, 522 and 622. Another one of these molding processes is generally known as two-shot molding which uses one machine that first molds the frame 412, 512 and 612 and then moves the mold cavity to reveal a second stage mold which enables the rubber-like substance 422, 522 and 622 to be injected over the frame 412, 512 and 612 which never leaves the machine. Either of these processes or similar processes can be used to fabricate the lid 400, 500 and 600.

Although several embodiments of the present invention has been illustrated in the accompanying Drawings and described in the foregoing Detailed Description, it should be understood that the invention is not limited to the embodiments disclosed, but is capable of numerous rearrangements, modifications and substitutions without departing from the spirit of the invention as set forth and defined by the following claims.

## Claims

1. A lid configured to cover a microplate, said lid comprising:
a frame including a plurality of downwardly protruding necks each of which is sized to fit and seal against one of a plurality of wells formed within the microplate.

2. A protein crystallography system, comprising:
a microplate; and
a lid, said lid having a plurality of downwardly protruding necks that fit and seal against a plurality of wells within said microplate;
each neck has a bottom side with an inner surface;
said inner surface having disposed thereon a drop, said drop including a protein solution and a first reagent solution that hangs over each microplate well;
a second reagent solution of a concentration greater than said first reagent solution placed within each microplate well;
wherein said drop of each neck interacts via a vapor diffusion process with the second reagent solution within each corresponding well, and turns the drop into a protein crystal.

3. A method for growing protein crystals, said method comprises the steps of:
providing a protein crystallography hanging drop lid, said lid having a frame with a plurality of downwardly protruding necks, each of which has a bottom side located with an inner surface, and a microplate,
prepping said protein crystallography hanging drop lid, including depositing a protein solution and a reagent solution on a bottom side of each neck;
providing a microplate, said microplate having a frame with a plurality of wells formed therein.
prepping said microplate, including depositing in each of said wells a reagent solution with a concentration greater than that of said reagent solution on the bottom side of each neck in said protein crystallography hanging drop lid; and
placing said protein crystallography hanging drop lid over said microplate such that each neck fits and seals against a rim of each well;
interacting said protein solution and said reagent solution on the bottom side of each neck via a vapor diffusion process with the reagent solution within each well in a manner that enables said protein solution to form a protein crystal.

4. The invention according to any one of the preceding claims 1-3, wherein each neck fits and seals against an outside edge of a rim of each well.

5. The invention according to any one of the preceding claims 1-3, wherein each neck fits and seals against an inside edge of a rim of each well.

6. The invention according to any one of the preceding claims 1-3, wherein each neck has a surface with a substance that forms a relatively tight seal with each well.

7. The invention according to any one of the preceding claims 1-3, wherein said substance is a rubber-like material.

8. The invention according to any one of the preceding claims 1-3, wherein said substance is a thermoplastic elastomer.

9. The invention according to any one of the preceding claims 1-3, each neck has a window formed in the frame that enables a user to see inside each well.

10. The invention according to any one of the preceding claims 1-3, wherein said lid includes a plurality of microfluidic channels which enable a user to load said protein drop from a top side of each neck to hang from said bottom side of each neck.

11. The invention according to any one of the preceding claims 1-3, wherein each bottom side is a concaved bottom side.

12. The invention according to any one of the preceding claims 1-3, wherein said frame of said lid has a footprint capable of being manipulated by a robotic handling system.
